# EUROPEAN PATENT SPECIFICATION

(11) **EP 4 107 791 B1**
(45) Date of publication and mention of the grant of the patent: **18.11.2026**
(21) Application number: 21756972.2
(22) Date of filing: 18.02.2021
(51) Int. Cl.: H10H 20/811, H10H 20/812, H10H 20/813, H10H 20/818, H10H 20/825, H10H 20/01, H10H 20/80, H10H 20/831, H10H 20/84

(54) **NANOWIRE AND LIGHT EMITTING DEVICE WITH AN ARRAY OF NANOWIRES**
NANODRAHT UND LICHTEMITTIERENDE VORRICHTUNG MIT EINEM ARRAY VON NANODRAHTEN
NANOFIL ET DISPOSITIF ÉLECTROLUMINESCENT AVEC UN RÉSEAU DE NANOFILS

(30) Priority: 18.02.2020 US 202062978168 P
(43) Date of publication of application: 28.12.2022
(73) Proprietor: The Regents of The University of Michigan, Ann Arbor, MI 48109-2590 (US); NS Nanotech, Inc., Ann Arbor, MI 48105 (US)
(72) Inventor: LIU, Xianhe, Ann Arbor, MI 48109-2590 (US); WU, Yuanpeng, Ann Arbor, MI 48109-2590 (US); MALHOTRA, Yakshita, Ann Arbor, MI 48109-2590 (US); SUN, Yi, Ann Arbor, MI 48109-2590 (US); COE-SULLIVAN, Seth, Redondo Beach, CA 90278 (US); STEVENSON, Matthew, Ann Arbor, MI 48103 (US); MI, Zetian, Ann Arbor, MI 48109-2590 (US)
(74) Representative: Dilg, Haeusler, Schindelmann Patentanwaltsgesellschaft mbH
(86) International application number: PCT/US2021/018559
(87) International publication number: WO 2021/168098

(56) References cited:
- US-A1- 2016 365 480
- US-A1- 2019 013 440
- US-B2- 9 112 085
- YONG-HO RA ET AL: "An electrically pumped surface-emitting semiconductor green laser", SCIENCE ADVANCES, vol. 6, 3 January 2020 (2020-01-03), pages 1 - 8, XP055838615
- RA YONG-HO ET AL: "Supplementary Materials for "An electrically pumped surface-emitting semiconductor green laser"", vol. 6, no. 1, 3 January 2020 (2020-01-03), US, pages 1 - 13, XP093125591, ISSN: 2375-2548, Retrieved from the Internet <URL:https://www.science.org/doi/suppl/10.1126/sciadv.aav7523/suppl_file/aav7523_sm.pdf> DOI: 10.1126/sciadv.aav7523
- LIU XIANHE ET AL: "Micrometer scale InGaN green light emitting diodes with ultra-stable operation", APPLIED PHYSICS LETTERS, AMERICAN INSTITUTE OF PHYSICS, 2 HUNTINGTON QUADRANGLE, MELVILLE, NY 11747, vol. 117, no. 1, 8 July 2020 (2020-07-08), XP012248317, ISSN: 0003-6951, [retrieved on 20200708], DOI: 10.1063/5.0005436
- YONG-HO RA, ROKSANA TONNY RASHID , XIANHE LIU, SHARIF MD. SADAF, KISHWAR MASHOOQ, ZETIAN MI: "An electrically pumped surface-emitting semiconductor green laser", SCIENCE ADVANCES, vol. 6, 3 January 2020 (2020-01-03), pages 1 - 8, XP055838615
- SADAF S. M., ZHAO S., WU Y., RA Y.-H., LIU X., VANKA S., MI Z.: "An AlGaN Core–Shell Tunnel Junction Nanowire Light-Emitting Diode Operating in the Ultraviolet-C Band", NANO LETTERS, AMERICAN CHEMICAL SOCIETY, US, vol. 17, no. 2, 8 February 2017 (2017-02-08), US, pages 1212 - 1218, XP055838621, ISSN: 1530-6984, DOI: 10.1021/acs.nanolett.6b05002
- LIU XIANHE, MASHOOQ KISHWAR, LALEYAN DAVID A., REID ERIC T., MI ZETIAN: "AlGaN nanocrystals: building blocks for efficient ultraviolet optoelectronics", PHOTONICS RESEARCH, vol. 7, no. 6, 1 June 2019 (2019-06-01), pages B12 - B23, XP055838622, DOI: 10.1364/PRJ.7.000B12

## Description

### RELATED U.S. APPLICATION

This application claims priority to the U.S. Provisional Application entitled "Micrometer Scale InGaN Green Light Emitting Diodes with Ultra-Stable Operation," by Xianhe Liu et al., Serial No. 62/978,168, filed February 18, 2020.

### BACKGROUND

High-efficiency, high-brightness light-emitting diodes (LEDs) with sizes on the order of the micrometer scale are highly desired for a broad range of applications, including virtual/mixed/augmented reality, ultrahigh resolution mobile displays, and biomedical sensing and imaging, to name just a few. In this regard, the development of gallium nitride (GaN)-based micro-LEDs has attracted significant interest in the past decade. To date, however, it has remained challenging to realize high-efficiency LEDs on the micrometer scale using conventional organic or inorganic materials.

While GaN-based large-area blue quantum well LEDs can exhibit high efficiency emission, the efficiency degrades drastically with decreasing device size, which has been limited to a large extent by the surface recombination and poor p-type conduction induced by top-down etching. Moreover, to achieve green emission, relatively high indium (In) compositions are required in the quantum well active region, which increases the formation of defects and dislocations and increases phase separation, resulting in weak and broad emission and therefore poor device efficiency and color quality.

The performance of InGaN-based quantum well LEDs also suffers severely from the quantum-confined Stark effect, particularly in the green spectrum, due to the strain-induced polarization field, which leads to unstable operation such as a significant shift in the emission wavelengths with increasing current. Organic LEDs, on the other hand, suffer from poor stability, low brightness, and drastically reduced efficiency with decreasing size.

The article "An electrically pumped surface-emitting semiconductor green laser" by Yong-Ho Ra et al., Science Advances, Vol. 6, pages 1-8, published on January 3rd 2020, addresses a promising generation of surface-emitting laser diodes using bottom-up grown InGaN/AlGaN core-shell quantum disk heterostructures embedded in GaN-based nanowires.

The document 2019/0013440 A1 discloses dilute-antimonide group-III nitride-based nanowires having light-emitting GaSbN/GaN quantum wells or quantum dots, and an LED comprising an array of said nanowires.

### SUMMARY

The present invention addresses a nanowire in accordance with the appended claim 1. The present invention also addresses a nanowire-based device in accordance with the appended claim 6. Further, advantageous embodiments of the present invention are the object of the appended dependent claims. Disclosed and in accordance with the present invention are micrometer-scale light emitting diodes (LEDs) that are operable for spontaneous emission of light at significantly reduced current densities and with a very narrow linewidth. In embodiments of the present invention as defined by the appended claims, each nanowire has a two-dimensional optical cavity that operates as a photonic bandgap that results in or modifies (affects or alters; e.g., enhances or amplifies) the spontaneous emission (and hence may be referred to as a weak optical cavity). In embodiments of the present invention as defined by the appended claims, the current density is at least an order of magnitude less than ten kiloamperes per square centimeter (10 kA/cm²), and the spectral linewidths are measured to be approximately four nanometers.

Accordingly, embodiments according to the present invention as defined by the appended claims achieve high-efficiency LEDs on the micrometer scale, provide stable operation and high color quality, and are largely free of defects and dislocations.

These and other objects and advantages of the various embodiments of the present invention as defined by the appended claims will be recognized by those of ordinary skill in the art after reading the following detailed description of the embodiments that are illustrated in the various drawing figures.

### BRIEF DESCRIPTION OF DRAWINGS

The accompanying drawings, which are incorporated in and form a part of this specification and in which like numerals depict like elements, illustrate embodiments of the present invention as claimed and, together with the detailed description, serve to explain the principles of the present invention as claimed. The drawings are not necessarily to scale.
Figure 1A illustrates a top-down or cross-sectional view of a nanowire array, in embodiments according to the present invention as claimed.
Figure 1B illustrates an energy band diagram for an example of a nanowire array in embodiments according to the present invention as claimed.
Figure 2A illustrates a nanowire light emitting diode (LED) structure in embodiments according to the present invention as claimed.
Figure 2B illustrates a nanowire array in embodiments according to the present invention as claimed.
Figure 2C illustrates an example of a photoluminescence spectrum for a nanowire array in embodiments according to the present invention as claimed.
Figure 3A illustrates an example of a microscale LED device in embodiments according to the present invention as claimed.
Figure 3B illustrates the current-voltage characteristics of an example of a microscale LED device in embodiments according to the present invention as claimed.
Figure 4A illustrates the electroluminescence (EL) spectra of a nanowire LED measured under varying injection currents, in embodiments according to the present invention as claimed.
Figure 4B illustrates relative external quantum efficiency versus injection current density, in embodiments according to the present invention as claimed.
Figure 5A illustrates an example of the emission properties of nanowire LEDs, in embodiments according to the present invention as claimed.
Figure 5B illustrates an example of the variation of the full-width-at-half-maximum of EL spectra of nanowire LEDs, in embodiments according to the present invention as claimed.
Figure 6 illustrates the angular distribution of the EL intensity of nanowire LEDs, in embodiments according to the present invention as claimed.

### DETAILED DESCRIPTION

Reference will now be made in detail to the various embodiments of the present invention as claimed, examples of which are illustrated in the accompanying drawings. While described in conjunction with these embodiments, it will be understood that they are not intended to limit the disclosure of the present invention to these embodiments. On the contrary, the present invention is intended to cover alternatives and modifications, which are included within the scope of the present invention as defined by the appended claims. Furthermore, in the following detailed description of the present invention, numerous specific details are set forth in order to provide a thorough understanding of the present invention. However, it will be understood that the present invention may be practiced without these specific details. In other instances, well-known methods, procedures, components, and circuits have not been described in detail so as not to unnecessarily obscure aspects of the present invention as defined by the appended claims.

The figures are not necessarily drawn to scale, and only portions of the devices and structures depicted, as well as the various layers that form those structures, are shown. For simplicity of discussion and illustration, only one or two devices or structures may be described, although in actuality more than one or two devices or structures may be present or formed. Also, while certain elements, components, and layers are discussed, embodiments according to the invention are not limited to those elements, components, and layers; as long as falling under the scope of the present invention as defined by the appended claims. For example, there may be other elements, components, layers, and the like in addition to those discussed.

Some portions of the detailed descriptions that follow are presented in terms of procedures and other representations of operations for fabricating devices like those disclosed herein. These descriptions and representations are the means used by those skilled in the art of device fabrication to most effectively convey the substance of their work to others skilled in the art. In the present specification, a procedure, operation, or the like, is conceived to be a self-consistent sequence of steps or instructions leading to a desired result. Operations described as separate blocks may be combined and performed in the same process step (that is, in the same time interval, after the preceding process step and before the next process step). Also, the operations may be performed in a different order than the order in which they are described below. Furthermore, fabrication processes and steps may be performed along with the processes and steps discussed herein; that is, there may be a number of process steps before, in between, and/or after the steps shown and described herein. Importantly, embodiments according to the present invention can be implemented in conjunction with these other (perhaps conventional) processes and steps without significantly perturbing them. Generally speaking, embodiments according to the present invention can replace portions of a conventional process without significantly affecting peripheral processes and steps.

Embodiments according to the disclosed invention realize micrometer scale light emitting diodes (LEDs or micro-LEDs or nanowire LEDs) with III-nitride nanowires, and with high efficiency, high color quality, and highly stable operation. Such nanostructures are largely free of defects and dislocations due to efficient surface strain relaxation.

The disclosed nanowire LEDs employ a vertical p-i-n configuration (in which a layer is sandwiched between a p-doped region and an n-doped region) that can significantly simplify the device fabrication process. The emission wavelengths can be tuned across nearly the entire visible light spectrum, especially including the green spectrum, by varying indium compositions in the quantum dots embedded in the nanowire structure.

Surface recombination, a major limiting factor for the efficiency of nanoscale and microscale LEDs, can be largely suppressed by employing a core-shell structure at the device active region as disclosed herein. Significantly, the disclosed nanowire structures provide highly stable and efficient photoluminescence emission, with the absence of Varshni and quantum-confined Stark effects commonly seen in wurtzite indium gallium nitride (InGaN) structures, by employing scalable band-edge modes in InGaN nanowire photonic crystals.

Disclosed herein are photonic nanowire tunnel junction surface-emitting LEDs that are designed to operate at the gamma (Γ) point of the photonic band structure. In embodiments, the device active region has an areal size of approximately three square-micrometers (µm²). In embodiments, the electroluminescence (EL) spectra exhibit a very narrow linewidth of approximately four nanometers (nm), which is nearly five to ten times smaller than that of conventional InGaN quantum wells (disks or dots) operating in the same wavelength range.

Significantly, the disclosed devices show highly stable spontaneous emission (as opposed to stimulated emission). There are virtually no variations of the emission peak with increasing current density, suggesting the absence of the quantum-confined Stark effect. In embodiments, the external quantum efficiency (EQE) exhibits a sharp rise with increasing current and reaches a maximum at approximately five amperes per square-centimeter (A/cm²). A relatively small (approximately 30 percent) efficiency droop was measured at an injection current density over 200 A/cm² at room temperature. Such small size, ultra-stable LEDs are well-suited for near-eye display applications.

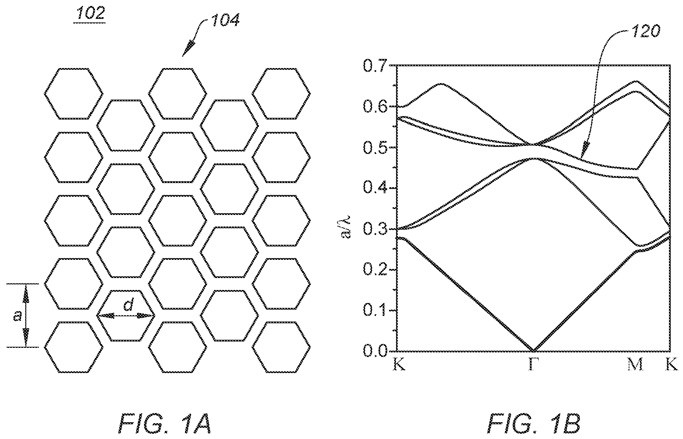

The optical design of the disclosed photonic nanowire LEDs is first described. Figure 1A illustrates a top-down or cross-sectional view of a nanowire array 102, in embodiments according to the present invention as claimed. The nanowire array 102 includes a number of nanocrystals, or nanowires, exemplified by the nanowire 104. (Each nanowire is a nanocrystal, and an array of nanocrystals includes an array of nanowires, and so these terms may be used interchangeably herein.) Each nanowire 104 has a hexagonal shape; that is, they each have a transverse cross-section that is hexagonal. The array 102 includes multiple rows of nanowires, with each row including multiple nanowires.

In the illustrated embodiment, the nanowire array 102 is arranged in a triangular lattice, which may also be known as a hexagonal lattice. The lateral size and the lattice constant (pitch) of the nanowires 104 are denoted as d and a, respectively. In an embodiment, d is equal to 298 nm and a is equal to 280 nm. The diameter of each of the nanowires 104 can vary from approximately 100 nm up to the dimension of the lattice constant. The size, spacing, and surface morphology of the nanowires 104 in the array 102 are precisely controlled. The nanowires 104 exhibit uniform length, smooth sidewalls, and high (depth-to-width) aspect ratio. Due to the efficient strain relaxation, the nanostructures of the nanowires 104 are free of defects and dislocations.

Figure 1B illustrates an energy band diagram calculated using a two-dimensional (2D) finite-element method for an example of a nanowire array in embodiments according to the present invention as claimed. In the example, the nanowire array has d equal to 298 nm and a equal to 280 nm.

In embodiments according to this disclosure, the InGaN photonic nanowire LEDs are designed to operate at the Γ point of the fourth band photonic band structure (the curve labeled 120 in the figure) where the in-plane wavevector is zero. As such, the overall wavevector is along the vertical direction of the photonic nanowire array (orthogonal to the plane of the substrate on which the array is located), which leads to direct surface emission. Furthermore, the group velocity is significantly reduced at the Γ point, resulting in long interaction time for the optical field and the active medium. Strong resonance at the corresponding wavelength can therefore be realized, which can lead to significantly reduced spectral linewidth.

In embodiments, the normalized frequency of the Γ point of the fourth band is approximately 0.504 a/λ (where a is the lattice constant, and λ is wavelength), which corresponds to a wavelength of approximately 555 nm with a lattice constant equal to 280 nm. Because the emission is largely governed by the optical resonance of the photonic nanowire, rather than by the semiconductor active medium itself, light emission of such LEDs is expected to be highly stable and relatively invariant with temperature and injection current. Furthermore, the peak emission wavelength of such an LED is locally invariant with changes in Group III (e.g., In) doping in the quantum wells, leading to an LED wafer (e.g., a monolithic device) that emits light at a constant peak wavelength despite small variations in doping across the wafer/array, such as variations that can occur in manufacturing processes for epitaxial growth such as metal-organic chemical vapor deposition (MOCVD) or molecular beam epitaxy (MBE) processes. Those features can furthermore eliminate the need for LED wavelength binning, which is an expensive post-process operation that adds cost to the fabrication of and decreases the value of LED wafers.

In embodiments, the technique of selective area epitaxy (SAE) was used to grow InGaN photonic nanowire LED structures. In an embodiment, the growth was performed on an n⁺-GaN template on a sapphire substrate using an MBE system equipped with a radio frequency plasma-assisted nitrogen source.

Generally speaking, the nanowire 104 includes a first semiconductor region, a second semiconductor region, and a heterostructure disposed between and coupled to the first semiconductor region and the second semiconductor region, where the first semiconductor region includes n-doped GaN and the second semiconductor region includes p-doped GaN.

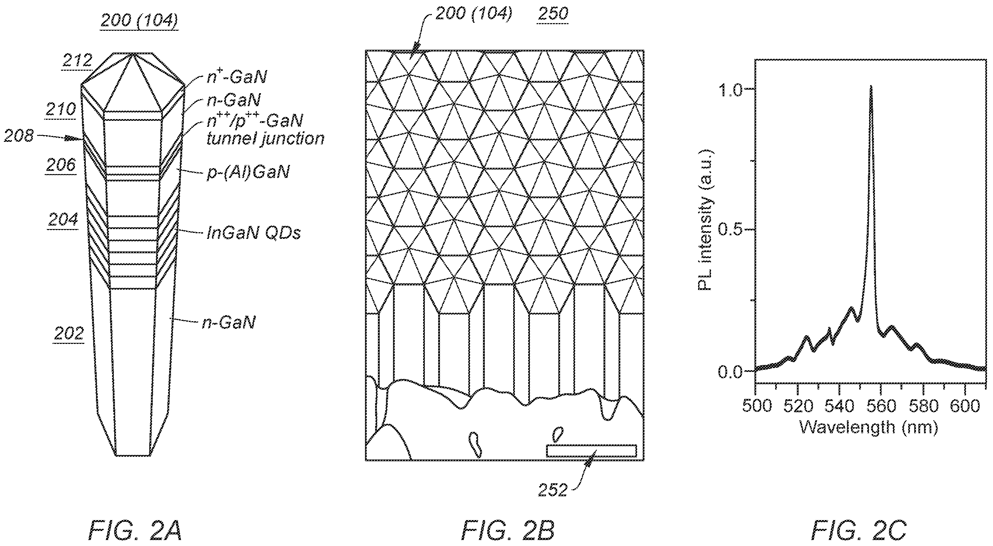

Figure 2A illustrates a nanowire LED structure 200 in embodiments according to the present invention as claimed. The LED structure 200 is representative of the structures of the nanowires 104 of Figure 1A.

In embodiments, the optical cavity of each nanowire 200 (104) is along the x- and y-axes and not the z-axis, but spontaneous light emission is along the z-axis (where the x- and y-axes are parallel to the plane of the device substrate, and the z-axis is normal to that plane). Thus, while the optical cavity is in the x and y directions, spontaneous light emission is in a different direction: the z direction, along the longitudinal axis of the nanowire. The disclosed x- and y-axis optical cavity configuration is referred to herein as a two-dimensional (2D) optical cavity. In contrast, a typical optical cavity (for a laser) is only along the z-axis (normal to the device substrate) and the stimulated emission of light is along that same axis, and so is known as a one-dimensional (1D) optical cavity.

The cavity effect provided by the disclosed nanowire arrays is used to achieve more directional emission as just described and also to achieve narrower spectral linewidths. The spectral linewidths are measured to be approximately four nm, which is nearly five to ten times smaller than those of conventional InGaN quantum well LEDs in that wavelength range.

The disclosed 2D optical cavity may be referred to as a weak cavity because the spontaneous emission is enhanced (or amplified) in the cavity, but stimulated emission is not achieved (in a strong optical cavity, stimulated emission can be achieved). The nanowire design parameters (e.g., diameter and lattice constant) are chosen to operate in a regime that is close to, but not exactly at, the photonic band edge of the nanowire array. By operating near this regime, the weak cavity effect is achieved. It is important to note that the operating window for a weak cavity is relatively larger compared to that of a strong cavity. As used herein, "operation close to but not (exactly) at the photonic band edge" or "operation as a photonic bandgap that modifies (or affects or alters) the spontaneous emission" or the like also means "operation as a photonic bandgap that results in enhanced or amplified spontaneous emission but does not result in stimulated emission." More specifically, for InGaN for example, the spontaneous emission typically shows a very broad spectrum (e.g., full-width-at-half-maximum (FWHM) in the range of 30 to 50 nm) in the green wavelength range, and the emission direction is often random; however, with the 2D photonic crystal effect achieved according to the embodiments disclosed herein, the spontaneous emission is modified so that the linewidth is much narrower and emission is more directional, as discussed above.

In the Figure 2A embodiments, the LED structure 200 includes an n⁺-GaN layer 202, a number of (e.g., six) vertically aligned InGaN/AlGaN quantum dots (QDs) 204, a p*-(Al)GaN cladding layer 206, a p⁺⁺-GaN/n⁺⁺-GaN tunnel junction 208, an n-GaN layer 210, and an n⁺⁺-GaN contact layer 212. In an embodiment, the thickness of the n⁺-GaN layer 202 is approximately 450 nm, the thickness of the p⁺-(Al)GaN cladding layer 206 is approximately 60 nm, and the thickness of the n-GaN layer 210 is approximately 60 nm. In an embodiment, the n-type dopant is silicon (Si) and the p-type dopant is magnesium (Mg).

In embodiments, the quantum dot active region 204, i.e. the set of InGaN/AlGaN quantum dots, includes alternating or interleaved layers of InGaN and AlGaN. For example, a layer of InGaN (which may be referred to as a core layer) is adjacent to a layer of AlGaN (which may be referred to as a shell or barrier layer), and this pattern is repeated in the quantum dot active region 204. The use of an AlGaN barrier, instead of a GaN barrier, during the growth of the quantum dot active region 204 promotes the formation of an Al-rich AlGaN shell structure surrounding the active region, which can significantly reduce surface recombination. In an embodiment, the average Al composition is about five percent.

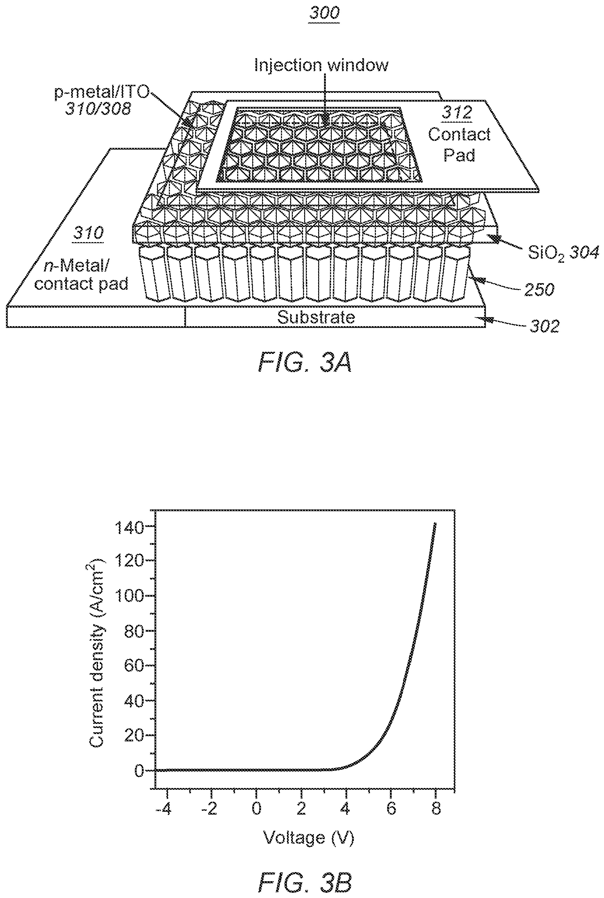

Prior to the SAE growth process, the substrate is patterned with openings to facilitate the formation of a highly regular nanowire array. More specifically, a thin (approximately ten nm) titanium (Ti) layer is deposited as a growth mask on a GaN-on-sapphire substrate (the substrate 302 of Figure 3A). E-beam lithography and reactive ion etching techniques can be used to define the pattern of openings on the Ti mask. Nanowires are formed only in the openings, with no epitaxy taking place on the Ti mask layer.

The resultant nanowire array 250 is shown in Figure 2B. The nanowire array 250 exhibits very high uniformity in both position and dimension. With careful control over the spacing between nanowires and the lattice constant, strong resonance in a selected color spectrum of the visible light spectrum. In the embodiment of Figure 2B, the length of the scale bar 252 represents 500 nm. Of particular interest, the green spectrum is observed from the photoluminescence (PL) of an InGaN photonic nanowire array with a lattice constant of 280 nm and a spacing of around 20 nm, as shown in Figure 2C.

Microscale LEDs are also fabricated using the photonic nanowire arrays grown by SAE. An embodiment of a microscale LED 300 is shown in Figure 3A.

Embodiments of a process for fabricating the microscale LED 300 are as follows. A silicon dioxide (SiO₂) layer 304 (e.g., 300 nm thick) is deposited by plasma enhanced chemical vapor deposition for surface passivation and isolation. Photolithography and wet chemical etching are performed to create openings in the SiO₂ layer 304, which defines the device active area for current injection. A metal stack (e.g., a five nm layer of Ti and a five nm layer of gold (Au)) is deposited by e-beam evaporation to form the contact pad 306. Subsequently, a transparent conducting oxide layer 308 (e.g., a 180 nm indium tin oxide (ITO) layer) is deposited by sputtering. A metal stack (e.g., a five nm layer of Ti and a five nm layer of Au) is also deposited to form the n-contact metal 310. Annealing may then be performed (e.g., at 400°C for one minute under a nitrogen ambient environment). Then, a metal layer is deposited by e-beam evaporation to form the contact pad 312, to facilitate electrical probing and measurements.

The current-voltage (I-V) characteristics of the microscale LED 300 are shown in Figure 3B. The microscale LED 300 has a turn-on voltage of approximately four volts, with negligibly small reverse bias leakage. The current density can readily reach 100 A/cm² at approximately seven volts without any degradation of the I-V characteristics. The electrical performance can be further improved by optimizing the doping and fabrication process.

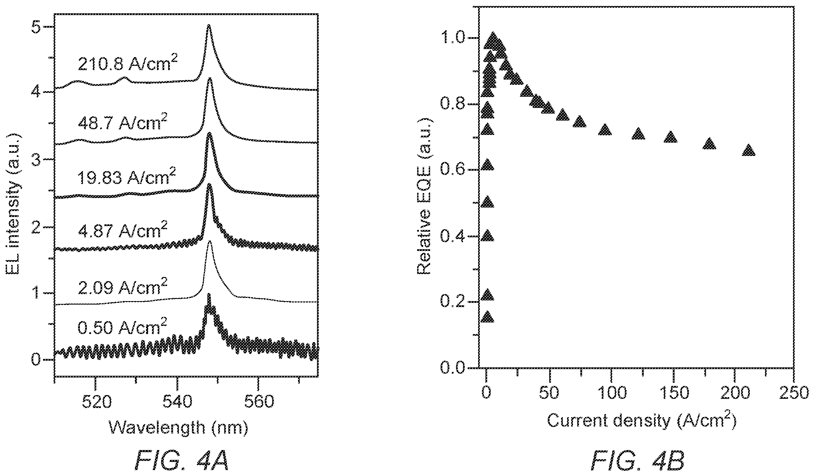

The output characteristics of an example of the disclosed InGaN photonic nanowire LEDs were measured for the green spectrum. The EL spectra were measured for current densities varying from 0.5 A/cm² to over 200 A/cm², which is at least an order of magnitude less than ten kiloamperes per square centimeter (kA/cm²). The measurement results are shown in Figure 4A. In that example, the emission spectra exhibit a pronounced peak emission at approximately 548 nm.

The spectral linewidths are measured to be approximately four nm, which is nearly five to ten times smaller than those of conventional InGaN quantum well LEDs in that wavelength range. Moreover, the emission peak does not show any noticeable shift or broadening with increasing current. Such distinct emission characteristics have not been measured in any conventional planar InGaN quantum well LEDs in this wavelength range.

The relative EQE, defined as the integrated EL intensity divided by current density, is shown in Figure 4B. The relative EQE shows a sharp increase with injection current density and reaches a maximum at about five A/cm². The sharp rise of EQE with injection current suggests a very small Shockley-Read-Hall recombination coefficient, which is attributed to the significantly reduced defect formation in the disclosed nanowires and also to suppressed non-radiative surface recombination with the use of the core-shell dot-in-nanowire active region. The efficiency droop is moderate, with only about a 30 percent drop in the EQE at a current density of more than 200 A/cm². Such a moderate efficiency droop also suggests a small Auger recombination coefficient in nearly defect-free InGaN nanowires.

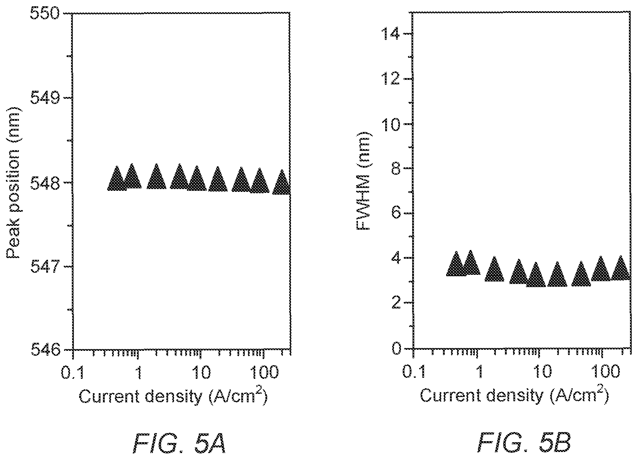

An example of the emission properties of the disclosed InGaN photonic nanowire LEDs are shown for wavelengths of green light in Figure 5A. In this example, the peak position remains extremely stable at approximately 548 nm as the injection current density increases from 0.5 A/cm² to 211 A/cm². Significantly, the spectral linewidths are nearly invariant with injection current.

Variations of the FWHM of the EL spectra are shown for green light, for example, in Figure 5B. The FWHM only ranges between three nm and approximately 3.7 nm as the injection current density increases from 0.5 A/cm² to 211 A/cm² at room temperature without any active cooling. For comparison, conventional InGaN quantum well light emitters in the green wavelength range suffer severely from quantum-confined Stark effect, which exhibits significant blue-shift in the emission with increasing current accompanied by a large spectral broadening due to band filling effect.

The extraordinary stability of the disclosed InGaN photonic nanowire LEDs is attributed to the reduced strain distribution of InGaN dot-in-nanowire structures and, more importantly, the strong resonance at the Γ point of the photonic band structure, which largely governs the emission characteristics and is only determined by the geometry of photonic nanowires. The disclosed InGaN photonic nanowires grown by MBE are extremely stable even under harsh operating conditions. Such ultra-stable small size LEDs that can operate without the use of any active cooling is highly useful for near-eye display applications.

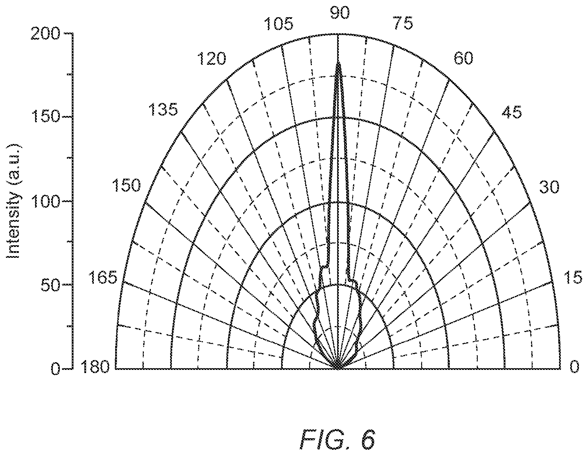

The far-field angular distribution of the emission was studied by collecting EL emission with a fiber that is mounted on a rotation stage. In that study, the distance between the fiber and the LED was one inch (25.4 mm). The EL intensity at each emission/collection angle was calculated by integrating over a spectral range from 543 nm to 553 nm. Figure 6 illustrates the angular distribution of the EL intensity for this example. It is seen that the emission is mainly distributed along the vertical direction, with a divergence angle of approximately ten degrees. Such optics-free, highly directional emission is directly related to the surface-emission mode at the Γ point of the InGaN photonic nanowire structures disclosed herein, which can greatly simplify the design and reduce the cost of next-generation ultrahigh resolution display devices and systems.

In conclusion, embodiments according to the present invention provide microscale LEDs, especially including but not limited to microscale green LEDs, utilizing InGaN photonic nanowires in accordance with the appended claims. By exploiting the unique resonance properties of the photonic band structure, such microscale devices can exhibit distinct emission characteristics, including a spectral linewidth that is five to ten times narrower than that of conventional InGaN quantum well LEDs, ultra-stable operation with the absence of quantum-confined Stark effect commonly seen in quantum well devices in this wavelength range, and highly directional emission. Moreover, the micrometer size LEDs exhibit a small efficiency droop under high injection current. Embodiments disclosed herein provide a new approach for achieving high efficiency, high brightness light emitters for next generation displays and for applications in emerging virtual/mixed/augmented reality devices and systems.

Although the subject matter has been described in language specific to structural features and/or methodological acts, it is to be understood that the subject matter defined in the present invention is not necessarily limited to the specific features or acts described above, but has to fall within the scope of the appended claims.

Embodiments according to the invention are thus described. While the present disclosure has been described in particular embodiments, the invention should not be construed as limited by such embodiments, but rather as defined by the following claims.

## Claims

1. A nanowire (200), comprising:
a first semiconductor region;
a second semiconductor region; and
a heterostructure disposed between and coupled to the first semiconductor region and the second semiconductor region;
wherein the nanowire is operable for spontaneous emission of light, and wherein the nanowire has a two-dimensional optical cavity that operates as a photonic bandgap that modifies the spontaneous emission, and
wherein the first semiconductor region, the heterostructure and the second semiconductor region comprise, in ascending order:
an n+ gallium nitride, n+-GaN, layer (202),
a plurality of vertically aligned indium GaN/aluminum GaN, InGaN/AlGaN, quantum dots (204),
a p+-AlGaN cladding layer (206),
a p++-GaN/n++-GaN tunnel junction (208),
an n-GaN layer (210), and
an n++-GaN contact layer (212).

2. The nanowire (200) of Claim 1, wherein the first semiconductor region comprises n-doped gallium nitride, and wherein the second semiconductor region comprises p-doped gallium nitride.

3. The nanowire (200) of Claim 1, wherein the heterostructure comprises shell layers and core layers, and wherein the core layers are interleaved with the shell layers.

4. The nanowire (200) of Claim 1, wherein the nanowire has a transverse cross-section that is hexagonal.

5. The nanowire (200) of Claim 1, wherein the n+-GaN layer (202) has a thickness of approximately 450 nanometers, nm, the p+-AlGaN cladding layer (206) has a thickness of approximately 60 nm, and the n-GaN layer (210) has a thickness of approximately 60 nm.

6. A device (300), comprising:
a substrate (302); and
a surface-emitting light-emitting diode, LED, coupled to the substrate and comprising a nanowire array (250) comprising a plurality of nanowires (200), wherein each nanowire of the plurality of nanowires is operable for generating a wavevector that is orthogonal to the substrate, wherein the electroluminescence spectra of said each nanowire has a linewidth less than or equal to approximately four nanometers nm,
wherein each nanowire of the plurality of nanowires comprises, in ascending order:
an n+ gallium nitride, n+-GaN, layer (202),
a plurality of vertically aligned indium GaN/aluminum GaN, InGaN/AlGaN, quantum dots (204),
a p+-AlGaN cladding layer (206),
a p++-GaN/n++-GaN tunnel junction (208),
an n-GaN layer (210), and
an n++-GaN contact layer (212).

7. The device (300) of Claim 6, wherein a peak emission wavelength is invariant with an amount of indium doping in the quantum dots (204).

8. The device (300) of Claim 6, wherein each nanowire (200) of the plurality of nanowires has a transverse cross-section that is hexagonal, and wherein the nanowires are arranged in a triangular lattice in the array (250).

## Patentansprüche

1. Nanodraht (200), aufweisend:
einen ersten Halbleiterbereich;
einen zweiten Halbleiterbereich; und
eine Heterostruktur, die zwischen dem ersten Halbleiterbereich und dem zweiten Halbleiterbereich angeordnet und mit diesen gekoppelt ist;
wobei der Nanodraht zur spontanen Emission von Licht betreibbar ist, und wobei der Nanodraht einen zweidimensionalen optischen Resonator aufweist, der als eine photonische Bandlücke arbeitet, die die spontane Emission modifiziert, und
wobei der erste Halbleiterbereich, die Heterostruktur und der zweite Halbleiterbereich in aufsteigender Reihenfolge aufweisen:
eine n+-Galliumnitrid-, n+-GaN-, Schicht (202),
eine Vielzahl von vertikal ausgerichteten Indium-GaN/Aluminium-GaN-, InGaN/AlGaN-, Quantenpunkten (204),
eine p+-AlGaN-Mantelschicht (206),
einen pt++-GaN/n++-GaN-Tunnelübergang (208),
eine n-GaN-Schicht (210), und
eine n++-GaN-Kontaktschicht (212).

2. Nanodraht (200) nach Anspruch 1, wobei der erste Halbleiterbereich n-dotiertes Galliumnitrid aufweist, und wobei der zweite Halbleiterbereich p-dotiertes Galliumnitrid aufweist.

3. Nanodraht (200) nach Anspruch 1, wobei die Heterostruktur Mantelschichten und Kernschichten aufweist, und wobei die Kernschichten mit den Mantelschichten verschachtelt sind.

4. Nanodraht (200) nach Anspruch 1, wobei der Nanodraht einen transversalen Querschnitt aufweist, der hexagonal ist.

5. Nanodraht (200) nach Anspruch 1, wobei die n+-GaN-Schicht (202) eine Dicke von ungefähr 450 Nanometern, nm, aufweist, die p+-AlGaN-Mantelschicht (206) eine Dicke von ungefähr 60 nm aufweist, und die n-GaN-Schicht (210) eine Dicke von ungefähr 60 nm aufweist.

6. Vorrichtung (300), aufweisend:
ein Substrat (302); und
eine oberflächenemittierende Leuchtdiode, LED, die mit dem Substrat gekoppelt ist und eine Nanodrahtanordnung (250) aufweist, die eine Vielzahl von Nanodrähten (200) aufweist, wobei jeder Nanodraht der Vielzahl von Nanodrähten betreibbar ist, um einen Wellenvektor zu erzeugen, der orthogonal zu dem Substrat ist,
wobei die Elektrolumineszenzspektren jedes Nanodrahts eine Linienbreite von weniger als oder gleich ungefähr vier Nanometern, nm, aufweisen,
wobei jeder Nanodraht der Vielzahl von Nanodrähten in aufsteigender Reihenfolge aufweist:
eine n+-Galliumnitrid-, n+-GaN-, Schicht (202),
eine Vielzahl von vertikal ausgerichteten Indium-GaN/Aluminium-GaN-, InGaN/AlGaN-, Quantenpunkten (204),
eine p+-AlGaN-Mantelschicht (206),
einen p++-GaN/n++-GaN-Tunnelübergang (208),
eine n-GaN-Schicht (210), und
eine n++-GaN-Kontaktschicht (212).

7. Vorrichtung (300) nach Anspruch 6, wobei eine Spitzenemissionswellenlänge mit einer Menge an Indiumdotierung in den Quantenpunkten (204) invariant ist.

8. Vorrichtung (300) nach Anspruch 6,
wobei jeder Nanodraht (200) der Vielzahl von Nanodrähten einen transversalen Querschnitt aufweist, der hexagonal ist, und wobei die Nanodrähte in einem dreieckigen Gitter in der Anordnung (250) angeordnet sind.

## Revendications

1. Un nanofil (200), comprenant :
- une première région de semiconducteur ;
- une deuxième région de semiconducteur ; et
- une hétérostructure disposée entre, et couplée à, la première région de semiconducteur et la deuxième région de semiconducteur ;
dans lequel le nanofil est opérable pour une émission spontanée de lumière, et dans lequel le nanofil a une cavité optique à deux dimensions qui opère en tant que bande interdite qui modifie l'émission spontanée, et
dans lequel la première région de semiconducteur, l'hétérostructure et la deuxième région de semiconducteur comprennent, par ordre croissant :
- une couche (202) de nitrure de gallium de type n+, n+-GaN,
- une pluralité de boîtes quantiques de GaN d'indium/GaN d'aluminium, InGaN/AlGaN, verticalement alignées (204),
- une couche de revêtement p+- AlGaN (206),
- une jonction tunnel p++-GaN/n++-GaN (208),
- une couche n-GaN (210), et
- une couche de contact n++-GaN (212).

2. Le nanofil (200) selon la revendication 1, dans lequel la première région de semiconducteur comprend du nitride de gallium dopé de type n, et dans lequel la deuxième région de semiconducteur du nitride de gallium dopé de type p.

3. Le nanofil (200) selon la revendication 1, dans lequel l'hétérostructure comprend des couches de coquille et des couches de cœur, et dans laquelle les couches de cœur sont entrelacées avec les couches de coquille.

4. Le nanofil (200) selon la revendication 1, dans lequel le nanofil comporte une coupe transversale qui est hexagonale.

5. Le nanofil (200) selon la revendication 1, dans lequel la couche n+-GaN a une épaisseur d'environ 450 nanomètres, nm, la couche de revêtement p+- AlGaN (206) a une épaisseur d'environ 60 nm, et la couche n-GaN (210) a une épaisseur d'environ 60 nm.

6. Un dispositif (300), comprenant :
- un substrat (302) ; et
- une diode électroluminescente, LED, à émission de surface, couplée au substrat et comportant un réseau de nanofils (250) comprenant une pluralité de nanofils (200), dans lequel chaque nanofil de la pluralité des nanofils est opérable pour générer un vecteur d'onde qui est orthogonal au substrat, dans laquelle spectre électroluminescent de chaque nanofil a une largeur de ligne inférieure ou égale à approximativement quatre nanomètres, nm,
- dans lequel chaque nanofil de la pluralité des nanofils comprend, par ordre croissant :
une couche (202) de nitrure de gallium de type n+, n+-GaN,
une pluralité de boîtes quantiques de GaN d'indium/GaN d'aluminium, InGaN/AlGaN, verticalement alignées (204),
une couche de revêtement p+- AlGaN (206),
une jonction tunnel p++-GaN/n++-GaN (208),
une couche n-GaN (210), et
une couche de contact n++-GaN (212).

7. Le dispositif (300) selon la revendication 6, dans lequel une longueur d'onde d'émission de pic est indépendante de la quantité du dopage d'indium dans les boîtes quantiques (204).

8. Le dispositif (300) selon la revendication 6, dans lequel chaque nanofil (200) de la pluralité des nanofils a une coupe transverse qui est hexagonale, et dans lequel les nanofils sont disposés dans un treillis triangulaire dans le réseau (250).
